(19)

**Europäisches Patentamt**
**European Patent Office**
**Office européen des brevets**

(11) **EP 4 513 798 A2**

(12) **EUROPEAN PATENT APPLICATION**

(43) Date of publication:
**26.02.2025 Bulletin 2025/09**

(21) Application number: **24193615.2**

(22) Date of filing: **08.08.2024**

(51) International Patent Classification (IPC):
**H04L 1/00** $^{(2006.01)}$ **H03M 13/13** $^{(2006.01)}$

(52) Cooperative Patent Classification (CPC):
**H04L 1/005; H03M 13/13; H04L 1/0057**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.08.2023 FI 20235943**

(71) Applicant: **Nokia Solutions and Networks Oy
02610 Espoo (FI)**

(72) Inventor: **ELKELESH, Ahmed
Stuttgart (DE)**

(74) Representative: **Nokia EPO representatives
Nokia Technologies Oy
Karakaari 7
02610 Espoo (FI)**

(54) **DECODING APPARATUS, METHOD, AND COMPUTER PROGRAM THEREFOR**

(57)    There is provided a method, computer program and receiver comprising a plurality of decoders for causing the receiver to perform: receiving (901) an encoded input signal, y, at each of the plurality of decoders; decoding (902), at each of the plurality of decoders, the input signal by processing check nodes in a respective order to obtain a plurality of decoded signals, $x_1,... ,x_L$, the respective orders being different for the plurality of decoders; determining (903) a plurality of valid codewords from the plurality of decoded signals; and determining (904) an output codeword as an estimate of the input signal from the plurality of valid codewords.

**FIG.9A**

**Description**

Field of the disclosure

The examples described herein generally relate to apparatus, methods, and computer programs, and more particularly (but not exclusively) to apparatus, methods and computer programs for apparatuses.

Background

A communication system can be seen as a facility that enables communication sessions between two or more entities such as communication devices, base stations and/or other nodes by providing carriers between the various entities involved in the communications path.

The communication system may be a communication system. Examples of communication systems comprise public land mobile networks (PLMN) operating based on radio standards such as those provided by 3GPP, satellite based communication systems and different wired and/or wireless local networks, for example wireless local area networks (WLAN).

The communication system and associated devices operate in accordance with a given set of standards or specifications that set out what the various entities associated with the system are permitted to do and how that is to be achieved. Communication protocols and/or parameters that are to be used for the connection are also typically defined. Examples of standards are the so-called 5G standards.

3GPP has issued a number of releases (Rel) for defining operating communication protocols related to a communications network. Currently, objectives and work are being set in relation to Releases 18 (Rel. 18) and 19 (Rel. 19).

Summary

According to a first aspect, there is provided a receiver comprising a plurality of decoders, the receiver being configured to: receive an encoded input signal, y, at each of the plurality of decoders; decode, at each of the plurality of decoders, the input signal by processing check nodes in a respective order to obtain a plurality of decoded signals, $x_1,...,x_L$, the respective orders being different for the plurality of decoders; determine a plurality of valid codewords from the plurality of decoded signals; and determine an output codeword as an estimate of the input signal from the plurality of valid codewords.

At least part of the decoding at the plurality of decoders may be performed simultaneously.

According to a second aspect, there is provided a receiver comprising a plurality of decoders, the receiver being configured to: receive an encoded input signal, y, at a first decoder of the plurality of decoders; decode, at the first decoder, the input signal by processing check nodes in a first order to obtain a first decoded signal, $x_1$; and determine whether to trigger a second decoder of the plurality of decoders to decode the encoded input signal based on a determination of whether the first decoded signal, $x_1$ is a valid codeword as an estimate of the input signal.

The receiver may be further configured to: in response to determining to trigger the second decoder, trigger the second decoder to decode the input signal by processing check nodes in a second order to obtain a second decoded signal, $x_2$, the second order being different to the first order; and determine whether the second decoded signal, $x_2$ is a valid codeword as an estimate of the input signal.

The receiver may be further configured to: abstain from sending a trigger to the second decoder to decode the input encoded signal by processing check nodes in a second order when it is determined that the first decoded signal is a valid codeword.

The receiver may be further configured to: in response to determining that the second decoded signal is an invalid codeword, trigger a third decoder to decode the input signal by processing check nodes in a third order to obtain a third decoded signal, $x_3$, the third order being different to the first order and the second order; and determine whether the third decoded signal, $x_3$ is a valid codeword as an estimate of the input signal.

In the above first and second aspects, the receiver may be further configured to: generate at least one of the first or second orders randomly or pseudorandomly.

In the above first and second aspects, the plurality of decoders may comprise at least one of: a flooding belief propagation decoder, a row-layered belief propagation decoder, or a column-layered belief propagation decoder.

In the above first and second aspects, the receiver may be further configured to: decode another input encoded signal at least one of the first decoder or the second decoder by processing check node(s) in the first and/or second order to obtain at least one other decoded signal, $x_L'$; determine another valid codeword from the at least one other decoded signal, $x_L'$; determine another output codeword as an estimate of the another input signal from the another valid codeword, wherein the output codeword is based on a first code, and the another output codeword is based on a second code. The first code may comprise a low-density parity-check code, and the second code may comprise a polar code.

According to a third aspect, there is provided a receiver comprising a plurality of decoders, the receiver further comprising: at least one processor; and at least one memory comprising code that, when executed by the at least one processor, causes the receiver to perform: receiving an encoded input signal, y, at each of the plurality of decoders; decoding, at each of the plurality of decoders, the input signal by processing check nodes in a respective order to obtain a plurality of decoded

signals, $x_1,...,x_L$, the respective orders being different for the plurality of decoders; determining a plurality of valid codewords from the plurality of decoded signals; and determining an output codeword as an estimate of the input signal from the plurality of valid codewords.

At least part of the decoding at the plurality of decoders may be performed simultaneously.

According to a fourth aspect, there is provided a receiver comprising a plurality of decoders, the receiver further comprising: at least one processor; and at least one memory comprising code that, when executed by the at least one processor, causes the receiver to perform: receiving an encoded input signal, y, at a first decoder of the plurality of decoders; decoding, at the first decoder, the input signal by processing check nodes in a first order to obtain a first decoded signal, $x_1$; and determining whether to trigger a second decoder of the plurality of decoders to decode the encoded input signal based on a determination of whether the first decoded signal, $x_1$ is a valid codeword as an estimate of the input signal.

The receiver may be further caused to perform: in response to determining to trigger the second decoder, triggering the second decoder to decode the input signal by processing check nodes in a second order to obtain a second decoded signal, $x_2$, the second order being different to the first order; and determining whether the second decoded signal, $x_2$ is a valid codeword as an estimate of the input signal.

The receiver may be further caused to perform: abstaining from sending a trigger to the second decoder to decode the input encoded signal by processing check nodes in a second order when it is determined that the first decoded signal is a valid codeword.

The receiver may be further caused to perform: in response to determining that the second decoded signal is an invalid codeword, triggering a third decoder to decode the input signal by processing check nodes in a third order to obtain a third decoded signal, $x_3$, the third order being different to the first order and the second order; and determining whether the third decoded signal, $x_3$ is a valid codeword as an estimate of the input signal.

In the above third and fourth aspects, the receiver may be further caused to perform: generating at least one of the first or second orders randomly or pseudorandomly.

In the above third and fourth aspects, the plurality of decoders may comprise at least one of: a flooding belief propagation decoder, a row-layered belief propagation decoder, or a column-layered belief propagation decoder.

In the above third and fourth aspects, the receiver may be further caused to perform: decoding another input encoded signal at least one of the first decoder or the second decoder by processing check node(s) in the first and/or second order to obtain at least one other decoded signal, $x_L$'; determining another valid codeword from the at least one other decoded signal, $x_L$'; determining another output codeword as an estimate of the another input signal from the another valid codeword, wherein the output codeword is based on a first code, and the another output codeword is based on a second code. The first code may comprise a low-density parity-check code, and the second code may comprise a polar code.

According to a fifth aspect, there is provided a method for a receiver comprising a plurality of decoders, the method comprising: receiving an encoded input signal, y, at each of the plurality of decoders; decoding, at each of the plurality of decoders, the input signal by processing check nodes in a respective order to obtain a plurality of decoded signals, $x_1,...,x_L$, the respective orders being different for the plurality of decoders; determining a plurality of valid codewords from the plurality of decoded signals; and determining an output codeword as an estimate of the input signal from the plurality of valid codewords.

At least part of the decoding at the plurality of decoders may be performed simultaneously.

According to a sixth aspect, there is provided a method for a receiver comprising a plurality of decoders, the method comprising: receiving an encoded input signal, y, at a first decoder of the plurality of decoders; decoding, at the first decoder, the input signal by processing check nodes in a first order to obtain a first decoded signal, $x_1$; and determining whether to trigger a second decoder of the plurality of decoders to decode the encoded input signal based on a determination of whether the first decoded signal, $x_1$ is a valid codeword as an estimate of the input signal.

The method may further comprise: in response to determining to trigger the second decoder, triggering the second decoder to decode the input signal by processing check nodes in a second order to obtain a second decoded signal, $x_2$, the second order being different to the first order; and determining whether the second decoded signal, $x_2$ is a valid codeword as an estimate of the input signal.

The method may further comprise: abstaining from sending a trigger to the second decoder to decode the input encoded signal by processing check nodes in a second order when it is determined that the first decoded signal is a valid codeword.

The method may further comprise: in response to determining that the second decoded signal is an invalid codeword, triggering a third decoder to decode the input signal by processing check nodes in a third order to obtain a third decoded signal, $x_3$, the third order being different to the first order and the second order; and determining whether the third decoded signal, $x_3$ is a valid codeword as an estimate of the input signal.

In the above fifth and sixth aspects, the method may comprise: generating at least one of the first or second orders randomly or pseudorandomly.

In the above fifth and sixth aspects, the plurality of decoders may comprise at least one of: a flooding belief propagation decoder, a row-layered belief propagation decoder, or a column-layered belief propagation decoder.

In the above fifth and sixth aspects, the method may further comprise: decoding another input encoded signal at least one of the first decoder or the second decoder by processing check node(s) in the first and/or second order to obtain at least one other decoded signal, $x_L'$; determining another valid codeword from the at least one other decoded signal, $x_L'$; determining another output codeword as an estimate of the another input signal from the another valid codeword, wherein the output codeword is based on a first code, and the another output codeword is based on a second code. The first code may comprise a low-density parity-check code, and the second code may comprise a polar code.

According to a seventh aspect, there is provided a receiver comprising a plurality of decoders, the receiver comprising: receiving circuitry for receiving an encoded input signal, y, at each of the plurality of decoders; decoding circuitry for decoding, at each of the plurality of decoders, the input signal by processing check nodes in a respective order to obtain a plurality of decoded signals, $x_1,...,x_L$, the respective orders being different for the plurality of decoders; determining circuitry for determining a plurality of valid codewords from the plurality of decoded signals; and determining circuitry for determining an output codeword as an estimate of the input signal from the plurality of valid codewords.

At least part of the decoding at the plurality of decoders may be performed simultaneously.

According to an eighth aspect, there is provided a receiver comprising a plurality of decoders, the receiver comprising: receiving circuitry for receiving an encoded input signal, y, at a first decoder of the plurality of decoders; decoding circuitry for decoding, at the first decoder, the input signal by processing check nodes in a first order to obtain a first decoded signal, $x_1$; and determining circuitry for determining whether to trigger a second decoder of the plurality of decoders to decode the encoded input signal based on a determination of whether the first decoded signal, $x_1$ is a valid codeword as an estimate of the input signal.

The receiver may further comprise: triggering circuitry for, in response to determining to trigger the second decoder, triggering the second decoder to decode the input signal by processing check nodes in a second order to obtain a second decoded signal, $x_2$, the second order being different to the first order; and determining circuitry for determining whether the second decoded signal, $x_2$ is a valid codeword as an estimate of the input signal.

The receiver may further comprise: abstaining circuitry for abstaining from sending a trigger to the second decoder to decode the input encoded signal by processing check nodes in a second order when it is determined that the first decoded signal is a valid codeword.

The receiver may further comprise: triggering circuitry for in response to determining that the second decoded signal is an invalid codeword, trigger a third decoder to decode the input signal by processing check nodes in a third order to obtain a third decoded signal, $x_3$, the third order being different to the first order and the second order; and determining circuitry for determine whether the third decoded signal, $x_3$ is a valid codeword as an estimate of the input signal.

In the above seventh and eighth aspects, the receiver may further comprise: generating circuitry for generating at least one of the first or second orders randomly or pseudorandom ly.

In the above seventh and eighth aspects, the plurality of decoders may comprise at least one of: a flooding belief propagation decoder, a row-layered belief propagation decoder, or a column-layered belief propagation decoder.

In the above seventh and eighth aspects, the receiver may further comprise: decoding circuitry for decoding another input encoded signal at least one of the first decoder or the second decoder by processing check node(s) in the first and/or second order to obtain at least one other decoded signal, $x_L'$; determining circuitry for determine another valid codeword from the at least one other decoded signal, $x_L'$; and determining circuitry for determining another output codeword as an estimate of the another input signal from the another valid codeword, wherein the output codeword is based on a first code, and the another output codeword is based on a second code. The first code may comprise a low-density parity-check code, and the second code may comprise a polar code.

According to a ninth aspect, there is provided non-transitory computer readable medium comprising program instructions for causing a receiver comprising a plurality of decoders to perform: receiving an encoded input signal, y, at each of the plurality of decoders; decoding, at each of the plurality of decoders, the input signal by processing check nodes in a respective order to obtain a plurality of decoded signals, $x_1,...,x_L$, the respective orders being different for the plurality of decoders; determining a plurality of valid codewords from the plurality of decoded signals; and determining an output codeword as an estimate of the input signal from the plurality of valid codewords.

At least part of the decoding at the plurality of decoders may be performed simultaneously.

According to a tenth aspect, there is provided non-transitory computer readable medium comprising program instructions for causing a receiver comprising a plurality of decoders to perform: receiving an encoded input signal, y, at a first decoder of the plurality of decoders; decoding, at the first decoder, the input signal by processing check nodes in a first order to obtain a first decoded signal, $x_1$; and determining whether to trigger a second decoder of the plurality of decoders to decode the encoded input signal based on a determination of whether the first decoded signal, $x_1$ is a valid codeword as an estimate of the input signal.

The receiver may be further caused to perform: in response to determining to trigger the second decoder, triggering the second decoder to decode the input signal by processing check nodes in a second order to obtain a second decoded signal, $x_2$, the second order being different to the first order; and determining whether the second decoded signal, $x_2$ is a valid codeword as an estimate of the input signal.

The receiver may be further caused to perform: abstaining from sending a trigger to the second decoder to decode the input encoded signal by processing check nodes in a second order when it is determined that the first decoded signal is a valid codeword.

The receiver may be further caused to perform: in response to determining that the second decoded signal is an invalid codeword, triggering a third decoder to decode the input signal by processing check nodes in a third order to obtain a third decoded signal, $x_3$, the third order being different to the first order and the second order; and determining whether the third decoded signal, $x_3$ is a valid codeword as an estimate of the input signal.

In the above ninth and tenth aspects, the receiver may be further caused to perform: generating at least one of the first or second orders randomly or pseudorandomly.

In the above ninth and tenth aspects, the plurality of decoders may comprise at least one of: a flooding belief propagation decoder, a row-layered belief propagation decoder, or a column-layered belief propagation decoder.

In the above ninth and tenth aspects, the receiver may be further caused to perform: decoding another input encoded signal at least one of the first decoder or the second decoder by processing check node(s) in the first and/or second order to obtain at least one other decoded signal, $x_L'$; determining another valid codeword from the at least one other decoded signal, $x_L'$; determining another output codeword as an estimate of the another input signal from the another valid codeword, wherein the output codeword is based on a first code, and the another output codeword is based on a second code. The first code may comprise a low-density parity-check code, and the second code may comprise a polar code.

In all of the above-mentioned aspects, the valid codeword may comprise a codeword of a linear block code.

In all of the above-mentioned aspects, the receiver may be comprised in a user equipment, or wherein the receiver is comprised in an access network node.

According to an eleventh aspect, there is provided a computer program product stored on a medium that may cause an apparatus to perform any method as described herein.

According to a twelfth aspect, there is provided an electronic device that may comprise apparatus as described herein.

According to a thirteenth aspect, there is provided a chipset that may comprise an apparatus as described herein.

Brief description of FIGs.

Some examples, will now be described, merely by way of illustration only, with reference to the accompanying drawings in which:

FIG. 1 shows schematic representations of a 5G system;
FIG. 2 shows a schematic representation of a network apparatus;
FIG. 3 shows a schematic representation of a user equipment;
FIG. 4A illustrates an encoder-decoder architecture;
FIGs. 4B and 4C illustrate decoding architectures;
FIG. 5 illustrates inputs and output of a belief propagation list decoder;
FIGs. 6 to 8 illustrate example decoder architecture; and
FIGs. 9A to 10 illustrate example operations that may be performed by apparatus comprised herein.

Detailed description

The following describes a decoder architecture that can be used to determine codewords associated with any type of encoding mechanism. Stated differently, a first encoded signal received at a receiver that was encoded in accordance with a first encoding scheme can be input to a same decoder as a second encoded signal received at the receiver that was encoded in accordance with a second encoding scheme. The first and second encoding mechanisms may be different. Examples of different encoding mechanisms comprise low density parity check (LDPC) code mechanisms and/or polar code mechanisms. It is understood that the first and/or second encoding mechanisms may comprise at least one other encoding mechanism than LDPC code mechanisms and/or polar code mechanisms. For example, the following described mechanisms may be applied in respect of any type of encoding mechanism associated with linear block code(s).

This decoder architecture may comprise hardware and/or software for processing a received signal for determining a valid codeword. The decoder architecture may be configured to use a plurality of different check node order permutations to output respective candidate codewords. The decoder architecture may comprise hardware and/or software for identifying a valid codeword using the respective candidate codewords. Examples of how this may be implemented are provided further below.

In the following description of examples, certain aspects are explained with reference to devices that are often capable of communication via a wireless cellular system and mobile communication systems serving such mobile communication devices. For brevity and clarity, the following describes such aspects with reference to a 5G wireless communication system. However, it is understood that such aspects are not limited to 5G wireless communication systems (or even to wireless communication systems), and may, for example, be applied to other wired communication systems and/or wireless communication systems (for example, current 6G proposals, IEEE 802.11, etc.). It is understood that references in the below to wireless communication systems and devices may also apply in respect of wired communication systems.

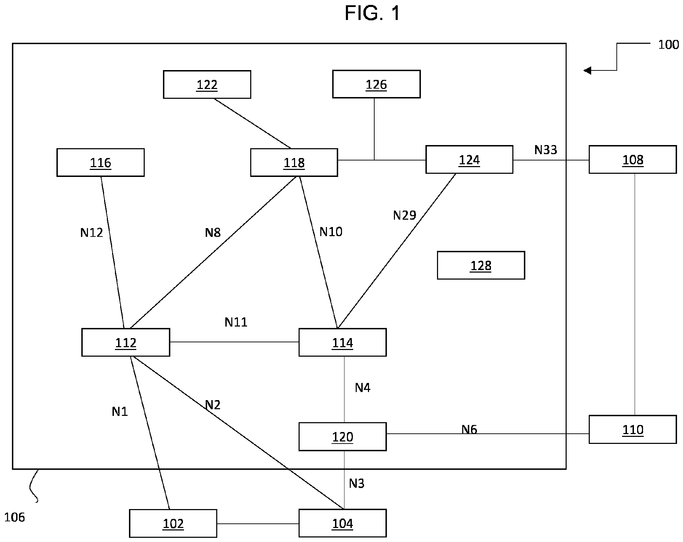

Before describing in detail the examples, certain general principles of a 5G wireless communication system are briefly explained with reference to FIG. 1.

FIG. 1 shows a schematic representation of a 5G system (5GS) 100. The 5GS may comprise a user equipment (UE) 102 (which may also be referred to as a communication device or a terminal), a 5G access network (AN) (which may be a 5G Radio Access Network (RAN) or any other type of 5G AN such as a Non-3GPP Interworking Function (N3IWF) /a Trusted Non3GPP Gateway Function (TNGF) for Untrusted / Trusted Non-3GPP access or Wireline Access Gateway Function (W-AGF) for Wireline access) 104, a 5G core (5GC) 106, one or more application functions (AF) 108 and one or more data networks (DN) 110.

The 5G RAN may comprise one or more gNodeB (gNB) distributed unit functions connected to one or more gNodeB (gNB) unit functions. The RAN may comprise one or more access nodes.

The 5GC 106 may comprise one or more Access and Mobility Management Functions (AMF) 112, one or more Session Management Functions (SMF) 114, one or more authentication server functions (AUSF) 116, one or more unified data management (UDM) functions 118, one or more user plane functions (UPF) 120, one or more unified data repository (UDR) functions 122, one or more network repository functions (NRF) 128, and/or one or more network exposure functions (NEF) 124. The role of an NEF is to provide secure exposure of network services (e.g. voice, data connectivity, charging, subscriber data, and so forth) towards a 3rd party. Although NRF 128 is not depicted with its interfaces, it is understood that this is for clarity reasons and that NRF 128 may have a plurality of interfaces with other network functions.

The 5GC 106 also comprises a network data analytics function (NWDAF) 126. The NWDAF is responsible for providing network analytics information upon request from one or more network functions or apparatus within the network. Network functions can also subscribe to the NWDAF 126 to receive information therefrom. Accordingly, the NWDAF 126 is also configured to receive and store network information from one or more network functions or apparatus within the network. The data collection by the NWDAF 126 may be performed based on at least one subscription to the events provided by the at least one network function.

Data transmitted between apparatus, particularly between a UE and an access point, is often encoded in order to guard against interference corrupting the transmitted data. For example, an encoder at a transmitter will encode data for transmission over a transmission channel by adding redundancy to the data (e.g., by interspersing code into the data). This encoded signal may then be transmitted to the receiver over the transmission channel. The receiver decodes the signal by removing the interspersed code. The receiver may determine whether the signal has been correctly received by extracting a word from the encoded signal, and determining whether the extracted word is a valid codeword. When the extracted word is determined to be a valid codeword, the received encoded signal may be determined to have been received and decoded correctly. When the extracted word is determined to be an invalid codeword, the received encoded signal may be determined to have been received and/or decoded incorrectly. In this latter case, the received encoded signal may be discarded without further processing.

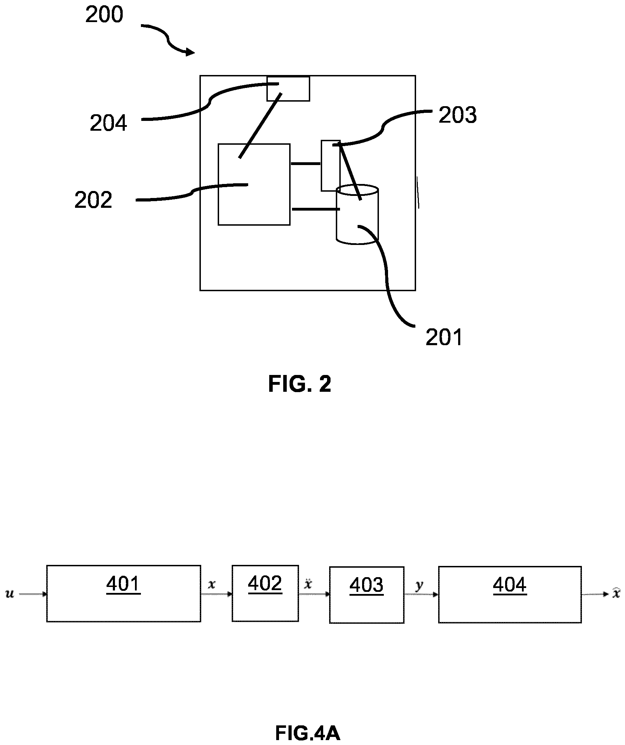

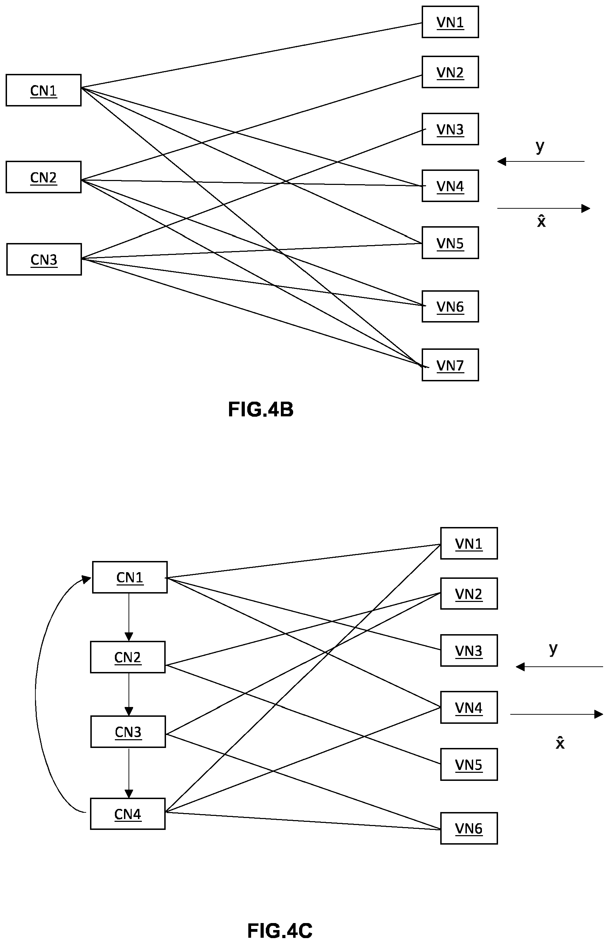

This process is illustrated with respect to FIGs. 4A, 4B, and 4C.

FIG. 4A illustrates a channel encoder 401 in a transmitter that receives a signal, $u$, for transmission to a receiver. The channel encoder 401 outputs a signal $x$ that represents an encoded version of the signal $u$. Signal $x$ is input to a modulation apparatus 402. The modulation apparatus 402 outputs a signal $\ddot{x}$ to a channel 403. The channel 403 outputs a signal $y$ to a channel decoder 404 at the receiver. The channel decoder 404 decodes $y$ to output $\hat{x}$.

There are several types of codes that may be used for encoding data for transmission. The following discusses the examples of Low-Density Parity-Check (LDPC) codes and polar codes as these are used in a variety of different communication protocols. However, it is understood, as mentioned above, that the presently described mechanisms may be used for any type of linear block code.

LDPC codes are linear error-correcting codes that are used to protect messages over noisy transmission channels. They are constructed using a sparse Tanner graph. A Tanner graph is a bipartite graph used to state constraints or equations that specify error correcting codes (e.g., a graph whose vertices may be divided into two independent sets, known as check nodes and variable nodes in the following). A channel code can be fully described by an (M X N) parity-check matrix H (referred to as H-matrix), where N represents a number of variable nodes (VNs) (e.g., a length of the code block) and M represents a number of check nodes (CNs). The check nodes may populate rows of the H-matrix, and the variable nodes may populate columns of the H-matrix.

LDPC codes are often decoded using an iterative message passing decoder (also known as a sum-product algorithm (SPA)). This is a modified version of the belief propagation (BP) algorithm introduced in 1962.

Soft messages, in form of log-likelihood ratios (LLRs), are exchanged over the Tanner graph of the code, which is a bipartite graph that divides nodes into N VNs and M CNs. A hardware-popular approximation called min-sum can be used to reduce the computational cost.

Belief propagation techniques treat each parity check that makes up the LDPC as an independent single parity check (SPC) code. Each SPC code is decoded separately using soft-in-soft-out (SISO) techniques, and other derivates thereof. The soft decision information from each SISO decoding is cross-checked and updated with other redundant SPC decodings of the same information bit. Each SPC code is then decoded again using the updated soft decision information. This process is iterated until a valid codeword is achieved or decoding is exhausted. This type of decoding is often referred to as sum-product decoding.

**The** decoding of the SPC codes is often referred to as the "check node" processing, and the cross-checking of the variables is often referred to as the "variable-node" processing.

LDPC decoding algorithms can be realized with different variants: Flooding decoding, and layered decoding.

Under LDPC Flooding decoding, assuming an $M \times N$ sized decoding matrix, LLR messages are flooded from N VNs to M CNs in parallel, and vice versa.

Under LDPC Layered decoding, CNs may be processed sequentially, incorporating the output of previous CNs already within the same iteration. Stated differently, the decoding algorithm may operate on rows of a parity-check matrix of the LDPC code and process each row separately, decode row-by-row (e.g., a top-to-bottom approach). This may result in a speedy convergence. Another variant of an LDPC layered decoding (also referred to as "column-layered" decoding), VNs are processed sequentially (e.g., decode column-by-column, which is also referred to as a left-to-right approach). LDPC decoders may be implemented based on the row-layered BP decoder with a min-sum approximation.

**A** polar code is a linear block error correcting code whose code construction is based on a multiple recursive concatenation of a short kernel code that transforms the physical channel into virtual outer channels. Polar codes may be decoded in a serial fashion (e.g., bit-by-bit). The original decoding method is the successive cancellation (SC) decoder, and current polar code decoding algorithms use a list decoding version called successive cancellation list (SCL) decoding.

In the example of FIG. 4A, a random bit generator (e.g., a source) may generate a block of $k$ bits labelled $\boldsymbol{u}$, which represents a vector of information bits. The values of "0" and "1" may be equi-probable in the vector, $\boldsymbol{u}$,.

Subsequently, a channel encoder (e.g., LDPC or polar encoder) 401 encodes (e.g., adds redundancy to) the information bit vector $\boldsymbol{u}$ to a codeword $\boldsymbol{x}$ of length $N$ (i.e., $\boldsymbol{x} = Enc(\boldsymbol{u})$).

A modulation apparatus 402 may then transform the codeword bits to symbols. This may be represented by the function $\ddot{\boldsymbol{x}} = mod(\boldsymbol{x})$.

**The** transmission channel 403 may comprise any type of transmission channel. For clarity and brevity, the following considers the transmission channel(s) between a transmitter and a receiver as comprising at least one of an Additive White Gaussian Noise (AWGN) channel and/or a Rayleigh fading channel. However, it is understood that these are merely being used as examples, and that the transmission channel may comprise any type of channel.

The AWGN channel may add Gaussian noise with zero mean and variance $\sigma^2$ to the signal transmitted over the transmission channel 403. In such a case, an introduced noise variance into the transmitted signal may be directly related to the AWGN channel's signal to noise ratio (SNR), for example, $\boldsymbol{y} = \ddot{\boldsymbol{x}} + noise$).

The Rayleigh fading channel may be modelled using Rayleigh fading model with full Channel State Information (CSI), which can be motivated as the result of an Orthogonal Frequency-Division Multiplexing (OFDM)-based transmission in a multipath propagation environment. This may be represented as, for example, $\boldsymbol{y} = \alpha.\ddot{\boldsymbol{x}} + noise,$ where $\alpha > 0$ is the fading coefficient that follows a Rayleigh distribution with $E[\alpha^2] = 1$ and is known to the receiver at each received bit position. The Rayleigh fading channel may be modelled using alternative modelling algorithms.

The transmission channel provides a signal to the channel decoder 404 located at the receiver. The channel decoder may therefore take, as an input, the output from the channel $\boldsymbol{y}$ (or noisy codeword) and return an estimated codeword after decoding (e.g., $\hat{\boldsymbol{x}} = Dec(\boldsymbol{y})$).

In a practical LDPC decoder implementation, sets of SPC codes are decoded in parallel to increase throughput. As mentioned above, this parallel processing is also referred to as flooding decoding, where check nodes are processed in parallel. This is illustrated with respect to FIG. 4B, in which check nodes are processed in parallel and their output combined to estimate the decoder output.

In the example of FIG. 4B, check node 1 (CN1) is connected with VN1, VN4, VN5, and VN7, check node 2 (CN2) is connected with VN2, VN4, VN6, and VN7, and check node 3 (CN3) is connected with VN3, VN5, VN6, VN7. The input signal is illustrated as y and the output is illustrated as $\hat{x}$. In the example of FIG. 4B, all VNs and CNs are updated in parallel. Stated differently, all messages are "flooded" in parallel from VNs to CNs (and vice versa).

FIG. 4C illustrates an example serial row-layered BP decoder. In the example of FIG. 4C, CN1 is connected to VN1, VN3, and VN4, CN2 is connected with VN2 and VN5, CN3 is connected with VN2 and VN6, and CN4 is connected with VN1, VN4, and VN6. The input signal is illustrated as y and the output is illustrated as $\hat{x}$. In the example of FIG. 4C, CNs are updated in a serial fashion (e.g., one-by-one) for each iteration of the algorithm.

FIG. 2 shows an example of a control apparatus for a communication system, for example to be coupled to and/or for controlling a station of an access system, such as a RAN node, e.g. a base station, gNB, a central unit of a cloud architecture or a node of a core network such as an Mobility Management Entity (MME) or Serving Gateway (S-GW), a scheduling entity such as a spectrum management entity, or a server or host, for example an apparatus hosting a network repository function (NRF), Network data analytics function (NWDAF), Access and Mobility Management Function (AMF), Session Management Function (SMF), Unified Data Management/Unified Data Repository (UDM/UDR), and so forth.

The control apparatus may be integrated with or external to a node or module of a core network or Radio Access Network (RAN). In some examples, base stations comprise a separate control apparatus unit or module. In other examples, the control apparatus can be another network element, such as a radio network controller or a spectrum controller. The control apparatus 200 can be arranged to provide control on communications in the service area of the system. The apparatus 200 comprises at least one memory 201, at least one data processing unit 202, 203 and an input/output interface 204. Via the interface the control apparatus can be coupled to a receiver and a transmitter of the apparatus. The receiver and/or the transmitter may be implemented as a radio front end or a remote radio head. For example, the control apparatus 200 or processor 201 can be configured to execute an appropriate software code to provide the control functions. References to "code" herein are understood to refer to software code, and vice versa.

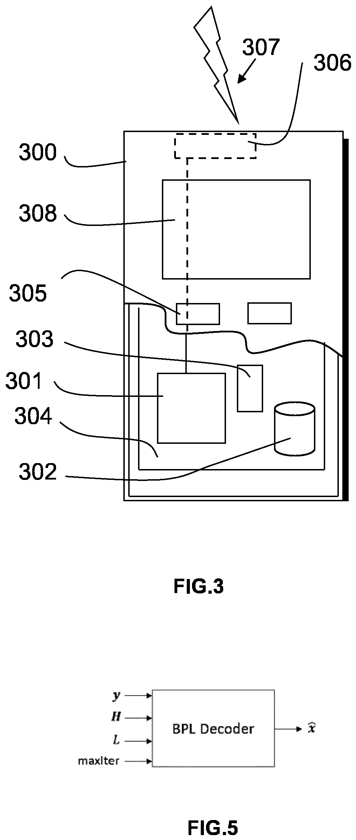

A possible wireless communication device will now be described in more detail with reference to FIG. 3 showing a schematic, partially sectioned view of a communication device 300. Such a communication device is often referred to as user equipment (UE) or terminal. An appropriate mobile communication device may be provided by any device capable of sending and receiving radio signals. Non-limiting examples comprise a mobile station (MS) or mobile device such as a mobile phone or what is referred to as a 'smart phone', a computer provided with a wireless interface card or other wireless interface facility (e.g., USB dongle), personal data assistant (PDA) or a tablet provided with wireless communication capabilities, or any combinations of these or the like. A mobile communication device may provide, for example, communication of data for carrying communications such as voice, electronic mail (email), text message, multimedia and so on. Users may thus be offered and provided numerous services via their communication devices. Non-limiting examples of these services comprise two-way or multi-way calls, data communication or multimedia services or simply an access to a data communications network system, such as the Internet. Users may also be provided broadcast or multicast data. Non-limiting examples of the content comprise downloads, television and radio programs, videos, advertisements, various alerts and other information.

A wireless communication device may be for example a mobile device, that is, a device not fixed to a particular location, or it may be a stationary device. The wireless device may need human interaction for communication, or may not need human interaction for communication. As described herein, the terms UE or "user" are used to refer to any type of wireless communication device.

The wireless device 300 may receive signals over an air or radio interface 307 via appropriate apparatus for receiving and may transmit signals via appropriate apparatus for transmitting radio signals. In FIG. 3, a transceiver apparatus is designated schematically by block 306. The transceiver apparatus 306 may be provided, for example, by means of a radio part and associated antenna arrangement. The antenna arrangement may be arranged internally or externally to the wireless device.

A wireless device is typically provided with at least one data processing entity 301, at least one memory 302 and other possible components 303 for use in software code and hardware aided execution of Tasks it is designed to perform, including control of access to and communications with access systems and other communication devices. The data processing, storage and other relevant control apparatus can be provided on an appropriate circuit board and/or in chipsets. This feature is denoted by reference 304. The user of the apparatus may control the operation of the wireless device by means of a suitable user interface such as keypad 305, voice commands, touch sensitive screen or pad, combinations thereof or the like. A display 308, a speaker and a microphone can be also provided. Furthermore, a wireless communication device may comprise appropriate connectors (either wired or' wireless) to other devices and/or for connecting external accessories, for example hands-free equipment, thereto.

In the above examples of decoders, after receiving a noisy sequence of data-samples, the receiver subsequently applies different receiver algorithms (such as, for example, equalization, demapping, and/or decoding algorithms) to extract the originally transmitted information. One of the most energy-intensive and time-consuming steps is the forward-error-correction (FEC) decoder (e.g., iterative BP decoding for LDPC codes and SCL decoding for polar codes, as discussed above).

The present application identifies that there are a number of problems associated with current decoders.

For example, currently, a receiver decodes received encoded signals using different encoding mechanisms by using respective decoder hardware for each encoding mechanisms (e.g., a first decoder hardware for decoding polar codes and a second decoder hardware for decoding LDPC codes). Having multiple decoder hardware in a same apparatus can be expensive in terms of both chip space and component cost.

Stated differently, in channel coding, there is a tailored decoder for every channel code, with some communication standards covering multiple channel codes. For example, as mentioned above, 5G communication protocols currently cover both LDPC codes and polar codes. In such a case, LDPC codes are decoded using an iterative BP decoder (such as described above in relation to FIGs. 4A to 4C, while polar codes are decoded with an SCL decoder. This dual decoder uses a custom decoding hardware (e.g., a decoder chip) per channel code, which increases the hardware cost and area.

Another issue relates to problems in decoding short length LDPC codes. As mentioned above, LDPC codes are often decoded using an iterative BP decoder. However, for short length LDPC codes, there is a huge performance gap between the iterative BP decoder and a maximum likelihood (ML) decoder (ML bound). Stated differently traditional decoders often offer much worse performance for short codes than for longer codes.

Another issue relates to decoding polar codes. As mentioned above, polar codes are decoded using SC-based decoders, where information bits are decoded bit-by-bit in a serial fashion.

SC-based decoders often output hard decisions for each bit with no reliability metric of the estimated bits (e.g., output is 0 or 1, with no context for this bit value). This is not always useful for iterative receivers that use iterative detection and/or decoding loops.

SC-based decoders are also often hard to parallelize, resulting in serial decoders. The use of serial decoders may lead to high-latency/low-throughput decoder implementations due to the bit-by-bit decoding nature.

To address at least one of the above mentioned issues, the following proposes a decoder architecture that can be used for decoding any type of linear block code. Stated differently, regardless of the code used to encode the signal, the encoder may feed a received encoded signal into a same decoder chip, which outputs an estimated codeword. The encoded signal may have been encoded via any encoding mechanism, such as, for example, LDPC and/or polar coding.

In essence, the following considers mechanisms for generating a diverse range codeword estimates from L decoders. This may be achieved by changing the check node update order.

In more detail, in current decoding systems, a top-to-bottom (row-by-row, check node-by-check node) update is employed, as discussed in relation to FIG. 4C. This is because, on average, any one check node order is equally good as any other check node order in a row-layered BP decoder.

However, the present application realises that, for a specific noise realization experienced by transmission of an encoded signal across a channel, a specific check node update order might be better. Stated differently, one CN update schedule might be better for a specific noise realization than another. The present application proposes to exploit this by varying a check node update order across L decoders, and using the output from at least one of these decoders to estimate a valid codeword.

From a slightly different perspective, an individual CN update schedule performance per noise realization may be different due to the different order of processing in the decoding graph. Therefore, whenever decoding fails using a specific check node update order, another check node update order can be used until a specific stopping condition is reached. In this manner way, a gain in error-correcting performance can be leveraged using an ensemble of BP decoders, without increasing the worst-case decoding latency.

It is understood that the number of permutations of check node updates may be very large. For example, for N check nodes, there may be N! different permutations. However, to make the decoding more efficient (in terms of hardware and/or software space, and/or processing time), only a fraction, L, of these different permutations may be checked, where L/N!<1. Therefore, in some examples, less than all of the different check node permutations may be checked. For example, for a code of length $N = 128$, code dimension $k = 64$, there are $(M)! = 64! \sim = 1.2688693 \times 10^{89}$ different check node update orders (or schedules). The permutations can be generated and/or represented by the vector $\pi = randperm(M)$, where $randperm(M)$ is a function that generates random permutations of a vector $\{1,2,3, ... , M\}$.

As mentioned above, there exists a large number of check node permutations, $M!$ (where M! may correspond to a (number of rows in the $H$-matrix)!, or to a (number of check nodes)! All those permutations will perform (on average) equally well, yielding a same error-rate performance. However, per noise realization, the different check node update order will perform differently (e.g., there is a different convergence behaviour: converge to a valid codeword or not, number of iterations needed for convergence, correct or wrong convergence). The presently described mechanisms aim to increase a list diversity by implementing different scheduling strategies.

This may be achieved by combining a plurality of row-layered BP decoders that are arranged to execute a check node update equation row-by-row (e.g., check-node by check-node). The order of check node updates may be varied between decoders.

In more detail, a straightforward way of implementing a check node-shuffled row-layered BP decoder is to permute the rows of the $H$-matrix according to the generated vector $\pi$ (i.e., $H' = H(\pi, :)$) and then apply the normal algorithm of updating row 1 followed by row 2 and so on till row M. Using this definition, an almost unlimited number of diverse/different BP decoders can be generated all based on the same algorithm (e.g., row-layered BP decoding). For clarity and brevity, the following examples consider $L$ parallel decoders such that $L$ is a user-defined parameter which leads to a performance-complexity trade-off (e.g., increasing $L$ leads to a better error-rate performance but with a higher complexity). The decoding latency is unchanged since it is assumed that all $L$ decoders are running in parallel.

**To** illustrate the presently described techniques, an LDPC decoding technique (namely the row-layered BP decoder) is modified in the following so that check nodes are processed in a variety of different combinations. This is illustrated with respect to the following examples relating to parallel decoding, serial decoding, and cascade decoding. All of these three examples relate to increasing the diversity of the order in which different check nodes updates are executed.

Further, for simplicity, the basic decoder considered in the following is a row-layered BP decoder. This decoder can be based on the SPA algorithm, the min-sum approximated algorithm, or any other variant of belief propagation decoders (e.g., normalized min-sum with correction, attenuated min-sum).

**An** example decoder is illustrated with reference to FIG. 5.

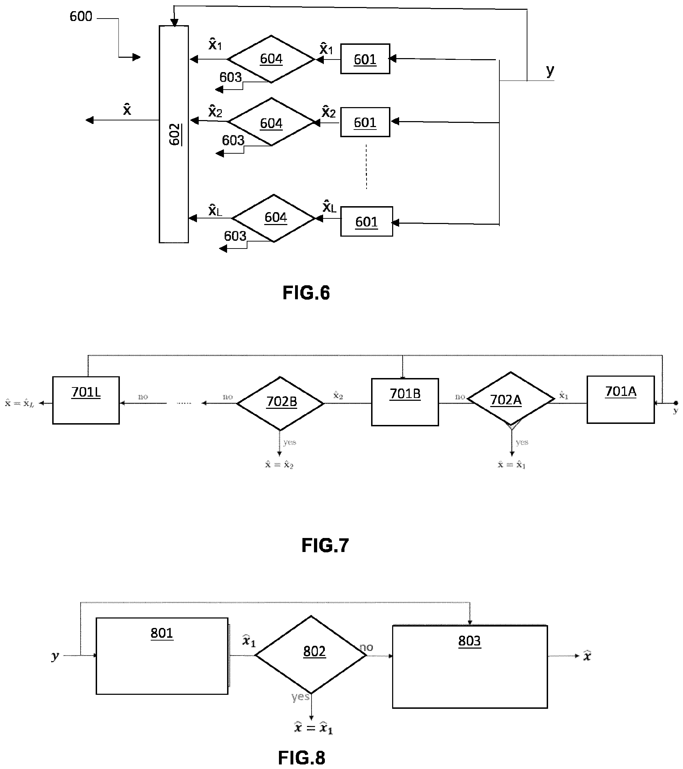

FIG. 5 illustrates a BP list (BPL) decoder that receives a plurality of inputs and outputs a codeword estimate, $\hat{x}$. The plurality of inputs may comprise, for example, a received noisy codeword y, a parity-check matrix H, a list size, L, and a maximum number of iterations per component decoder (maxlter). The BPL decoder may use the input to determine the output, as described below in relation to Figures 6 to 8.

There may be a plurality of different employed decoders that only differ in the Log-Likelihood Ratio (LLR) scheduling update order. The LLR scheduling update order may be considered as a changing an order of passing messages over a decoding graph. Examples include a flooding BP decoder, a row-layered BP decoder, and a column-layered BP decoder.

In practice, a row-layered BP decoder may be used to decode LDPC codes and may be efficiently/effectively implemented in hardware (e.g., high throughput, low latency, low area, etc.). Therefore, the following proposed decoder will be based on this row-layered BP decoder. However, it is understood that any other message update schedule can be used (e.g., column-layered belief propagation decoding). The aim here is to increase the list diversity which will enhance the decoder error-rate performance.

It is understood that any other decoder to those mentioned herein may be used as a component decoder to increase the list diversity. However, for simplicity and for reducing the component decoders to be implemented in-hardware, the following considers row-layered SPA BP decoding with different check node update order.

First, parallel decoding examples are considered.

In the presently described parallel decoding mechanism, $L$ parallel independent (e.g., row-layered) BP decoders are run, which may generate respective hypotheses. For example, the presently described decoder may comprise a plurality of parallel BP decoders (such as described above in relation to FIG. 4C) that are each configured to update their check nodes in a different order/different permutation to other BP decoders of the plurality of BP decoders. A single, most probable codeword may be selected from these generated valid codewords (e.g., using an "ML-in-the-list" rule).

The presently described parallel decoder system implements a plurality of respective permutations of an order of check nodes, $C_1$, $C_2$, ... $C_L$. For example, a first branch may implement a combination of check nodes in a first permutation (e.g., $C_1$, $C_2$, $C_3$, $C_4$, $C_5$), a second branch may implement a combination of check nodes in a second permutation (e.g., $C_2$, $C_4$, $C_5$, $C_1$, Cs), and so on.

Valid codewords output from the $L$ decoders are then identified (e.g., by parity-checking, such as $\hat{x} \cdot H^T = 0$, as described further below). One of the identified valid codewords may then be selected by finding a codeword that is closest to the noisy codeword y in terms of Euclidean distance (e.g., as discussed below in relation to FIG. 6 and a "ML-in-the-List" decision rule).

**An** example parallel decoder according to the present example is illustrated with respect to FIG. 6.

FIG. 6 illustrates a received encoded signal, y, that is input into L parallel branches of a decoder architecture 600 and into a selection function 602. Each of the parallel branches comprises a row-layered BP decoder 601 that is configured to process a respective check node order (e.g., to process different message scheduling).

For example, a first row-layered BP decoder 601 in a first decoding branch may receive signal y, process signal y with respect to a first permutation of check node update order (e.g., $C_1$, $C_2$, $C_3$, $C_4$, $C_5$), and output a first signal $\hat{x}_1$ to an evaluation function 604. The evaluation function determines whether the first signal $\hat{x}_1$ comprises a valid codeword. When the evaluation function 604 determines that signal $\hat{x}_1$ comprises a valid codeword, the evaluation function 604 outputs signal $\hat{x}_1$ to selection function 602. When a valid codeword is not identified by the evaluation function 604 in the first decoding branch, an invalid block error indication is output as 603.

Further, a second row-layered BP decoder 601 in a second decoding branch may receive signal y, process signal y with respect to a second permutation of check node update order (e.g., $C_2$, $C_4$, $C_5$, $C_1$, Cs), and output a second signal $\hat{x}_2$ to an evaluation function 604 comprised in the second decoding branch. The evaluation function determines whether the second signal $\hat{x}_2$ comprises a valid codeword. When the evaluation function 604 determines that signal $\hat{x}_2$ comprises a valid codeword, the evaluation function 604 outputs signal $\hat{x}_2$ to selection function 602. When a valid codeword is not identified by the evaluation function 604 in the second decoding branch, an invalid block error indication is output as 603.

Corresponding operations to those performed by the first and second decoding branches may be performed by the remaining parallel branches, albeit in respect of respective permutations of check nodes.

It is understood that the decoders provided in each branch do not have to be the same type of decoder. For example, a first decoder branch may comprise a decoder that operates in accordance with a flooding belief propagation algorithm, a second decoder may operate in accordance with a row-layered belief propagation algorithm (using a conventional order of check node updates), and the remaining decoders may comprise row-layered belief propagation algorithms (each decoder using a randomly permuted CN update order).

Since the component decoders are all independent in the example of FIG. 6, they can all run in parallel, which can potentially lead to high throughput implementations with a constraint on the (average and worst-case) decoding latency. Remember that the (average and worst-case) decoding latency in BP decoders is directly proportional to the (average and maximum) number of BP iterations.

The selection function 602 may comprise functionality (e.g., hardware and/or software) for selecting a valid codeword that is determined by the selection function as best fulfilling the combined output.

For example, in the example of FIG. 6, there are provided L parallel independent decoders yielding (e.g., outputting) L estimated words. In the present example, each decoder comprises a belief propagation decoder that works on a respective matrix $H(\pi_L)$, where L represents the Lth decoder, and $\pi_L$ represents a unique order (e.g., permutation) of check nodes of the parity check matrix, H. $H(\pi_L)$ of different belief propagation decoders in the different decoder branches therefore differ from each other by the order of the rows of the matrix, assuming the check nodes are provided as rows in the matrix, H.

Each of the L belief propagation decoders outputs a respective estimated word $\hat{x}_L$ to an evaluation function 604 in that decoder branch that assess a validity of the output. A validity of the output may be assessed by, for example, multiplying the output with the transpose of the matrix, H to determine whether the result equals zero (e.g., $(\hat{x}_L.H^T = 0)$). When the result does not equal zero (e.g., the word $\hat{x}_L$ is determined to be invalid, this is output as an indication of a block error at 603. When the result does equal zero (e.g., the word $\hat{x}_L$ is determined to be valid), this is output as $\hat{x}_L$ to a decision block (e.g., selection function 602).

The selection function 602 picks one estimated word, based on some predefined metric, and declares it as the final output, $\hat{x}_{BPL}$. In the present example, an "ML-in-the-list" rule is used. For example, the decision block may determine an output codeword $\hat{x}_{BPL}$ as:

$$\hat{x}_{BPL} = \underset{\hat{x}_i i\in\{1...L\}}{\arg} min\|y - \hat{x}_i\|$$

If no valid codeword is available (e.g., if no valid codeword is identified by the evaluation functions), the decoder may directly declare a decoding failure by indicating that a block error has occurred and, optionally, to select an output $\hat{x}_{BPL}$ according to a predefined metric that aims to reduce the number of bits identified as being in error.

A second example relating to a serial decoder is now considered.

In this second example, a first decoder processes a signal using a first order (e.g., permutation) of check nodes to output a first estimated word. When the first estimated word is determined to be valid, then the first estimated word is selected as an output codeword. When the first estimated word is determined to be invalid, the signal is processed by a second decoder that processes the signal using a second order of check nodes to output a second estimated word. This process may be continued until either a valid codeword is found, or a maximum of L decoders have been used.

This second example is illustrated with respect to FIG. 7.

FIG. 7 illustrates a signal y that is input into L decoders 701A, 701B, ... 701L.

A first decoder 701A determines a word, $\hat{x}_1$, using a first permutation of a plurality of check nodes. This word $\hat{x}_1$ is output to a first validity function 702A. The first validity determination function comprises hardware and/or software for determining whether $\hat{x}_1$ is a valid codeword. For example, when $(\hat{x}_1. H^T = 0)$, then $\hat{x}_1$ is determined to be a valid codeword. When $\hat{x}_1.H^T$ does not equal zero, then a trigger is provided to a second decoder, 701B.

The second decoder 701B determines a word, $\hat{x}_2$, using a second permutation of a plurality of check nodes, the second permutation being different to the first permutation. This word $\hat{x}_2$ is output to a second validity function 702B. The second validity determination function comprises hardware and/or software for determining whether $\hat{x}_2$ is a valid codeword. For example, when $(\hat{x}_2. H^T = 0)$, then $\hat{x}_2$ is determined to be a valid codeword. When $\hat{x}_2.H^T$ does not equal zero, then a trigger is provided to a third decoder, 701C (not shown). This process may be repeated at the different decoders using different check node update orders until either a valid codeword is identified, or until L decoders are reached. The check node update orders may be selected using a random generation mechanism, as discussed above.

The first example mechanism (parallel BPL) and the second example mechanism (serial BPL) have a performance-latency-complexity tradeoff therebetween.

For example, an average processing complexity of serial BPL may be lower than that of parallel BPL, while both have almost the same worst-case complexity. The error-rate performance comparison between these two examples may depend on the quality (or false alarm rate) of the stopping criteria (e.g., in dependence on an

accuracy of determining $\hat{x}.H^T = 0$).

In the third example mechanism, there is provided a BP decoder (e.g., a row-layered or flooding BP decoder) such as is used in current systems. When the output of the BP decoder does not result in a valid codeword, then one of the first and second mechanisms mentioned above may be deployed. This is illustrated with respect to FIG. 8.

FIG. 8 illustrates an encoded received signal, y, is input into a lower complexity decoder 801 (e.g., a row-layered BP decoder or a flooding BP decoder) and into a higher complexity decoder 803 (e.g., a parallel or serial decoder as described above in relation to FIGs. 6 and/or 7). A word $\hat{x}_1$ output from the lower complexity decoder 801 is input to a validity function 802. The validity function 802 may determine whether $\hat{x}_1$ corresponds to a valid codeword. This may be performed as discussed above in relation to any of the previous examples. When $\hat{x}_1$ is determined to be a valid codeword, the validity function outputs an indication that the codeword is $\hat{x}_1$. When $\hat{x}_1$ is determined to be an invalid codeword, the validity function 802 outputs a trigger to the higher complexity decoder 803. Receipt of the trigger at the higher complexity decoder 803 cases the higher complexity decoder to perform the mechanism of FIG. 6 and/or FIG. 7.

The cascade mechanism of FIG. 8 may be useful when the transmitting and receiving devices comprising the encoder and decoder respectively operate in the low error-rate region (e.g., operate when that packet errors are less probable).

**To** reduce the complexity of the proposed decoder examples, an SNR-dependent look-up table (or a pre-trained neural network) can be used to decide when to activate a decoder described above in relation to any of FIGs. 6 to 8.

For example, at a predefined (low) range of SNR values, a row-layered BP decoder may be used and, at a predefined (high) range of SNR values, the proposed BPL decoder of any of FIGs. 6 to 8 may be used. In other words, the decoder may be adjusted based on the estimated SNR. This means that decoding parameters may be adjusted dynamically (e.g., in real time) in response to the received channel observation y to optimize the energy-efficiency.

Further, the above-described decoders of FIGs. 6 to 8 may be potentially used for channel codes without a known explicit decoder when a sparse graph representation of the code is found.

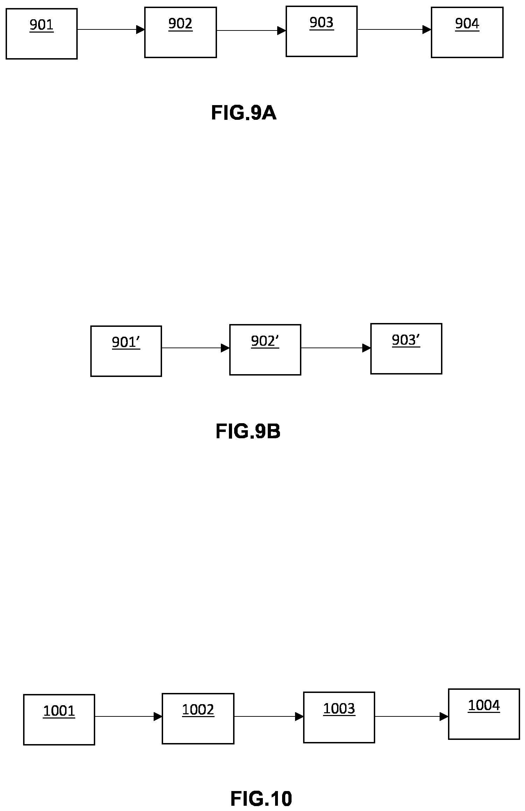

Features of the above examples are illustrated below with respect to FIGs. 9A to 10. It is therefore understood that at least one feature mentioned below may find functional correspondence to at least one feature mentioned in the above FIGs. Further, it is understood that the above-mentioned examples may be used to provide example context for deploying the presently described techniques.

FIGs. 9A to 9B illustrates operations that may be performed by receiver apparatus comprising a plurality of decoders. The receiver may receive signals wirelessly and/or via a wired connection. The receiver apparatus may be comprised in a user equipment. The receiver apparatus may be comprised in an access node (e.g., a gNB). The receiver apparatus may comprise a network node (e.g., a receiver located within a network).

FIG. 9A illustrates operations that may be performed by receiver comprising a plurality of decoders.

During 901, the receiver receives an encoded input signal, y, at each of the plurality of decoders. The encoded input signal, y, may be a signal received over a channel from a transmitter.

During 902, the receiver decodes, at each of the plurality of decoders, the input signal by processing check nodes in a respective order to obtain a plurality of decoded signals, $x_1,...,x_L$, the respective orders being different for the plurality of decoders. For example, a first decoder of the plurality of decoders may be configured to decode the input signal by processing check nodes in a first order to obtain a first decoded signal, a second decoder of the plurality of decoders may be configured to decode the input signal by processing check nodes in a second order to obtain a second decoded signal, a third decoder of the plurality of decoders may be configured to decode the input signal by processing check nodes in a third order to obtain a third decoded signal, and so on. The first order, second order, and third order are different to each other.

During 903, the receiver determines a plurality of valid codewords from the plurality of decoded signals.

During 904, the receiver determines an output codeword as an estimate of the input signal from the plurality of valid codewords.

**At** least part of the decoding at the plurality of decoders may be performed simultaneously. Stated differently, the plurality of decoders may be configured to decode the input signal in parallel.

FIG. 9B illustrates operations that may be performed by receiver comprising a plurality of decoders.

During 901', the receiver receives an encoded input signal, y, at a first decoder of the plurality of decoders. The encoded input signal may comprise a signal transmitted by a transmitter over a channel between the transmitter and the receiver.

During 902', the receiver decodes, at the first decoder, the input signal by processing check nodes in a first order to obtain a first decoded signal, $x_1$.

During 903', the receiver determines whether to trigger a second decoder of the plurality of decoders to decode the encoded input signal based on a determination of whether the first decoded signal, $x_1$ is a valid codeword as an estimate of the input signal.

**The** receiver may, in response to determining to trigger the second decoder (e.g., when it is determined that $x_1$ is not a valid codeword as an estimate of the input signal), trigger the second decoder to decode the input signal by processing check nodes in a second order to obtain a second decoded signal, $x_2$, the second order

being different to the first order. The receiver may determine whether the second decoded signal, $x_2$ is a valid codeword as an estimate of the input signal.

The receiver may abstain from sending a trigger to the second decoder to decode the input encoded signal by processing check nodes in a second order when it is determined that the first decoded signal is a valid codeword as an estimate of the input signal. In this case, the receiver may declare the first decoded signal as the output codeword.

The receiver may, in response to determining that the second decoded signal is an invalid codeword, trigger a third decoder to decode the input signal by processing check nodes in a third order to obtain a third decoded signal, $x_3$, the third order being different to the first order and the second order. The receiver may determine whether the third decoded signal, $x_3$ is a valid codeword as an estimate of the input signal.

In all of the above examples of FIGs. 9A to 9B, the receiver may be being further configured to: generate at least one of the first or second orders randomly or pseudorandom ly.

In all of the above examples of FIGs. 9A to 9B, the decoders of the plurality of decoders may comprise at least one of: a flooding belief propagation decoder, a row-layered belief propagation decoder, or a column-layered belief propagation decoder. For example, the first and/or second decoders may comprise at least one of: a flooding belief propagation decoder, a row-layered belief propagation decoder, or a column-layered belief propagation decoder.

In all of the above examples of FIGs. 9A to 9B, the receiver may be further configured to: decode another input encoded signal at least one of the first decoder or the second decoder by processing check node(s) in the first and/or second order to obtain at least one other decoded signal, $x_L'$; determine another valid codeword from the at least one other decoded signal, $x_L'$; determine another output codeword as an estimate of the another input signal from the another valid codeword, wherein the output codeword is based on a first code, and the another output codeword is based on a second code. Stated differently, the presently described receiver may be used to decode received input encoded signals that are encoded using different codes. For example, the first code may comprise a low-density parity-check code, and the second code may comprise a polar code.

In all of the above examples of FIGs. 9A to 9B, the valid codeword may comprise a codeword of a linear block code.

FIG. 10 illustrates operations that may be performed by an apparatus. The apparatus may be comprised in a decoder. The decoder may be comprised as part of a receiver. The receiver may receive signals wirelessly and/or via a wired connection. The apparatus may be comprised in a user equipment. The apparatus may be comprised in an access node (e.g., a gNB). The apparatus may comprise a network node (e.g., a receiver located within a network).

During 1001, the apparatus inputs a first received encoded signal into a first decoder and a second decoder, wherein the first decoder is configured to decode the first received encoded signal by processing check nodes in a first order, and the second decoder is configured to decode the first received encoded signal by processing check nodes in a second order.

The first order may comprise a first schedule. Stated differently, the first order may comprise a first check node update order. The second order may comprise a second schedule. Stated differently, the second order may comprise a second check node update order.

The first received encoded signal may comprise a signal received by the receiver over a channel. The first received encoded signal may comprise a signal portion (encoded by a transmitter of the first received encoded signal) and a noise portion (introduced via transmission of the signal portion from the transmitter over a channel).

It is understood that "first" and "second" are used in the above and the following to differentiate between different apparatus (e.g., the different decoders (and their various signalling)). This does not limit the following the presently described techniques to two such apparatus, and it is understood that more than two of such apparatus may be comprised in the apparatus and perform corresponding features to the first and second apparatus mentioned throughout.

During 1002, the apparatus outputs a respective estimated word from at least one of the first decoder or the second decoder by processing the first received encoded signal at said at least one first decoder or second decoder.

During 1003, the apparatus determines an output codeword based on the respective estimated word(s).

During 1004, the apparatus determines whether the first received encoded signal has been decoded correctly by determining whether the determined output codeword is a valid codeword.

When the apparatus determines that the first received encoded signal has been decoded correctly, the apparatus may output a codeword (e.g., the determined output codeword) for continuing with processing the first received encoded signal.

When the apparatus determines that the first received encoded signal has been decoded incorrectly, the apparatus may directly declare a decoding failure by indicating that a block error has occurred. In this latter case, the apparatus may select an output codeword according to a predefined metric that aims to reduce the number of bits identified as being in error.

The first and second decoder may be arranged in series. For example, the first decoder may determine, by processing check nodes in the first order, a first estimated word, determine whether the first estimated word is a valid codeword, and send a trigger to the second decoder to decode the first received encoded signal by processing check nodes in the second order when it is determined that the first estimated word is an invalid codeword. When the first estimated word is determined to be a valid codeword, the first decoder may abstain from sending a trigger to the second decoder to decode the first received encoded signal by processing check nodes in the second order. In this latter case, the second decoder does not decode the first received encoded signal. The second decoder may discard the first received encoded signal.

The first and second decoder may be arranged in parallel. For example, the first and second decoders may simultaneously process the first received encoded signal at the first decoder and the second decoder. In this case, the first decoder may determine, by processing check nodes in the first order, a first estimated word and the second decoder may determine, by processing check nodes in the second order, a second estimated word. Then determining the output codeword may be performed using both the first and second estimated words.

The apparatus may comprise a cascade mechanism, as described above. For example, the apparatus may input the first received encoded signal into a third decoder, wherein the third decoder is configured to decode the first received encoded signal by processing each check node, output a third estimated word from the third decoder by processing the first received encoded signal at said third decoder, determine whether the first received encoded signal has been decoded correctly by determining whether the third estimated word is a valid codeword, and trigger the first and/or second decoder to perform said outputting the respective estimated word(s) when it is determined that the third estimated word is an invalid codeword. The third decoder may comprise any type of decoder. As examples, the third decoder may comprise the decoder of FIG. 4B and/or FIG. 4C. As an example, the first and/or second decoder may be triggered to perform said outputting only when the third estimated word is an invalid codeword.

The apparatus may generate at least one of the first and second orders randomly or pseudorandomly.

The first and/or second decoder may comprise at least one of: a flooding belief propagation decoder, a row-layered belief propagation decoder, or a column-layered belief propagation decoder.

The presently described apparatus may be used in respect of multiple different types of codes (e.g., Reed Muller, polar codes, LDPC codes, etc.). For example, the apparatus may: input a second received encoded signal into the first decoder and the second decoder, output another respective estimated word from at least one of the first decoder or the second decoder by processing the second received encoded signal at said at least one first decoder or second decoder; determine a second output codeword based on the another respective estimated word(s), and determine whether the second received encoded signal has been decoded correctly by determining whether the determined second codeword is a valid codeword, wherein the first codeword is based on a first code, and the second codeword is based on a second code. For example, the first code may comprise a low-density parity-check code, and the second code may comprise a polar code.

In all of the above examples, the valid codeword may comprise a codeword of a linear block code. Stated differently, the apparatus described above (e.g., in respect of any of FIGs. 6 to 10) can be used signals encoded using any linear block code.

The foregoing description has provided by way of non-limiting examples a full and informative description of some examples. However, various modifications and adaptations may become apparent to those skilled in the relevant arts in view of the foregoing description, when read in conjunction with the accompanying drawings and the claims. However, all such and similar modifications of the teachings will still fall within the scope of the claims.

In the above, different examples are described using, as an example of an access architecture to which the described techniques may be applied, a radio access architecture based on long term evolution advanced (LTE Advanced, LTE-A) or new radio (NR, 5G), without restricting the examples to such an architecture, however. The examples may also be applied to other kinds of communications networks having suitable means by adjusting parameters and procedures appropriately. Some examples of other options for suitable systems are the universal mobile telecommunications system (UMTS) radio access network (UTRAN), wireless local area network (WLAN or Wi-Fi), worldwide interoperability for microwave access (WiMAX), Bluetooth®, personal communications services (PCS), ZigBee®, wideband code division multiple access (WCDMA), systems using ultra-wideband (UWB) technology, sensor networks, mobile ad-hoc networks (MANETs) and Internet Protocol multimedia subsystems (IMS) or any combination thereof.

As provided herein, various aspects are described in the detailed description of examples and in the claims. In general, some examples may be implemented in hardware or special purpose circuits, software code, logic or any combination thereof. For example, some aspects may be implemented in hardware, while other aspects may be implemented in firmware or software code which may be executed by a controller, microprocessor or other computing device, although examples are not limited thereto. While various examples may be illustrated and described as block diagrams, flow charts, or using some other pictorial representation, it is well understood that these blocks, apparatus, systems, techniques or methods described herein may be implemented in, as non-limiting examples, hardware, software code, firmware code, special purpose circuits or logic, general purpose hardware or controller or other computing devices, or some combination thereof.

The examples may be implemented by computer software code stored in a memory and executable by at least one data processor of the involved entities or by hardware, or by a combination of software code and hardware.

The memory referred to herein may be of any type suitable to the local technical environment and may be implemented using any suitable data storage technology, such as semiconductor based memory devices, magnetic memory devices and systems, optical memory devices and systems, fixed memory and removable memory.

The (data) processors referred to herein may be of any type suitable to the local technical environment, and may comprise one or more of general purpose computers, special purpose computers, microprocessors, digital signal processors (DSPs), application specific integrated circuits (ASIC), FPGA, gate level circuits and processors based on multi core processor architecture, as non-limiting examples.

Further in this regard it should be noted that any procedures, e.g., as in FIG. 9A, and/or FIG. 9B, and/or FIG. 10, and/or otherwise described previously, may represent operations of a computer program being deployed by at least one processor comprised in an apparatus (where a computer program comprises instructions for causing an apparatus to perform at least one action, the instructions being represented as software code stored on at least one memory), or interconnected logic circuits, blocks and functions, or a combination of operations of a computer program being deployed by at least one processor comprised in an apparatus and logic circuits, blocks and functions. The software code may be stored on memory, such as physical media as memory chips, or memory blocks implemented within the processor, magnetic media (such as hard disk or floppy disks), and optical media (such as for example DVD and the data variants thereof, CD, and so forth).

The memory may be of any type suitable to the local technical environment and may be implemented using any suitable data storage technology, such as semiconductor-based memory devices, magnetic memory devices and systems, optical memory devices and systems, fixed memory and removable memory. The data processors may be of any type suitable to the local technical environment, and may include one or more of general purpose computers, special purpose computers, microprocessors, digital signal processors (DSPs), application specific integrated circuits (ASIC), gate level circuits and processors based on multicore processor architecture, as nonlimiting examples.

Additionally or alternatively, some examples may be implemented using circuitry. The circuitry may be configured to perform one or more of the functions and/or method steps previously described. That circuitry may be provided in the base station and/or in the communications device and/or in a core network entity.

As used in this application, the term "circuitry" or "means" may refer to one or more or all of the following:

(a) hardware-only circuit implementations (such as implementations in only analogue and/or digital circuitry);

(b) combinations of hardware circuits and software code, such as:

(i) a combination of analogue and/or digital hardware circuit(s) with software/firmware code and
(ii) any portions of hardware processor(s) with software code (including digital signal processor(s)), software code, and memory(ies) that work together to cause an apparatus, such as the communications device or base station to perform the various functions previously described; and

(c) hardware circuit(s) and or processor(s), such as a microprocessor(s) or a portion of a microprocessor(s), that requires software code (e.g., firmware) for operation, but the software code may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware code. The term circuitry also covers, for example integrated device.

Implementations of the disclosure may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

As used herein, "at least one of the following: <a list of two or more elements>" and "at least one of <a list of two or more elements>" and similar wording, where the list of two or more elements are joined by "and" or "or", mean at least any one of the elements, or at least any two or more of the elements, or at least all the elements.

The term "non-transitory," as used herein, is a limitation of the medium itself (i.e., tangible, not a signal) as opposed to a limitation on data storage persistency (e.g., RAM vs. ROM).

The scope of protection sought for various examples of the disclosure is set out by the independent claims. The examples and features, if any, described in this specification that do not fall under the scope of the independent claims are to be interpreted as examples useful for understanding the disclosure.

The foregoing description has provided by way of non-limiting examples a full and informative description of example implementations of this disclosure. However, various modifications and adaptations may become apparent to those skilled in the relevant arts in view of the foregoing description, when read in conjunction with the accompanying drawings and the appended claims. However, all such and similar modifications of the teachings of this disclosure will still fall within the scope of this invention as defined in the appended claims. Indeed, there is a further implementation comprising a combination of one or more implementations with any of the other implementations previously discussed.

**Claims**

1. A receiver comprising a plurality of decoders, the receiver being configured to:

   receive (901) an encoded input signal, y, at each of the plurality of decoders;
   decode (902), at each of the plurality of decoders, the input signal by processing check nodes in a respective order to obtain a plurality of decoded signals, $x_1,...,x_L$, the respective orders being different for the plurality of decoders;
   determine (903) a plurality of valid codewords from the plurality of decoded signals; and
   determine (904) an output codeword as an estimate of the input signal from the plurality of valid codewords.

2. A receiver as claimed in claim 1, wherein at least part of the decoding at the plurality of decoders is performed simultaneously.

3. A receiver comprising a plurality of decoders, the receiver being configured to:

   receive (901') an encoded input signal, y, at a first decoder of the plurality of decoders;
   decode (902'), at the first decoder, the input signal by processing check nodes in a first order to obtain a first decoded signal, $x_1$; and
   determine (903') whether to trigger a second decoder of the plurality of decoders to decode the encoded input signal based on a determination of whether the first decoded signal, $x_1$ is a valid codeword as an estimate of the input signal.

4. A receiver as claimed in claim 3, the receiver being further configured to:

   in response to determining to trigger the second decoder, trigger the second decoder to decode the input signal by processing check nodes in a second order to obtain a second decoded signal, $x_2$, the second order being different to the first order; and
   determine whether the second decoded signal, $x_2$ is a valid codeword as an estimate of the input signal.

5. A receiver as claimed in claim 3, the receiver being further configured to:
   abstain from sending a trigger to the second decoder to decode the input encoded signal by processing check nodes in a second order when it is determined that the first decoded signal is a valid codeword.

6. A receiver as claimed in any of claims 4 to 5, the receiver being further configured to:

   in response to determining that the second decoded signal is an invalid codeword, trigger a third decoder to decode the input signal by processing check nodes in a third order to obtain a third decoded signal, $x_3$, the third order being different to the first order and the second order; and
   determine whether the third decoded signal, $x_3$ is a valid codeword as an estimate of the input signal.

7. A receiver as claimed in any preceding claim, the receiver being further configured to: generate at least one of the first or second orders randomly or pseudorandom ly.

8. A receiver as claimed in any preceding claim, wherein the plurality of decoders comprises at least one of: a flooding belief propagation decoder, a row-layered belief propagation decoder, or a column-layered belief propagation decoder.

9. A receiver as claimed in any preceding claim, wherein the receiver is further configured to:

   decode another input encoded signal at least one of the first decoder or the second decoder by processing check node(s) in the first and/or second order to obtain at least one other decoded signal, $x_L'$;
   determine another valid codeword from the at least one other decoded signal, $x_L'$; and
   determine another output codeword as an estimate of the another input signal from the another valid codeword,
   wherein the output codeword is based on a first code, and the another output codeword is based on a second code.

10. A receiver as claimed in claim 9, wherein the first code comprises a low-density parity-check code, and the second code comprises a polar code.

11. A receiver as claimed in any preceding claim, wherein the valid codeword comprises a codeword of a linear block code.

**12.** A receiver as claimed in any preceding claim, wherein the receiver is comprised in a user equipment, or wherein the receiver is comprised in an access network node.

**13.** A method for decoding an encoded input signal at a receiver comprising a plurality of decoders, the method comprising:

receiving (901) an encoded input signal, y, at each of the plurality of decoders;
decoding (902), at each of the plurality of decoders, the input signal by processing check nodes in a respective order to obtain a plurality of decoded signals, $x_1,...,x_L$, the respective orders being different for the plurality of decoders;
determining (903) a plurality of valid codewords from the plurality of decoded signals; and
determining (904) an output codeword as an estimate of the input signal from the plurality of valid codewords.

**14.** A computer program comprising instructions which, when executed by a receiver comprising a plurality of decoders, causes the receiver to perform:

receiving (901) an encoded input signal, y, at each of the plurality of decoders;
decoding (902), at each of the plurality of decoders, the input signal by processing check nodes in a respective order to obtain a plurality of decoded signals, $x_1,...,x_L$, the respective orders being different for the plurality of decoders;
determining (903) a plurality of valid codewords from the plurality of decoded signals; and
determining (904) an output codeword as an estimate of the input signal from the plurality of valid codewords

**15.** A method for decoding an encoded input signal at a receiver comprising a plurality of decoders, the method comprising:

receiving (901') an encoded input signal, y, at a first decoder of the plurality of decoders;
decoding (902'), at the first decoder, the input signal by processing check nodes in a first order to obtain a first decoded signal, $x_1$; and
determining (903') whether to trigger a second decoder of the plurality of decoders to decode the encoded input signal based on a determination of whether the first decoded signal is a valid codeword as an estimate of the input signal.

**16.** A computer program comprising instructions which, when executed by a receiver comprising a plurality of decoders, causes the receiver to perform:

receiving (901') an encoded input signal, y, at a first decoder of the plurality of decoders;
decoding (902'), at the first decoder, the input signal by processing check nodes in a first order to obtain a first decoded signal, $x_1$; and
determining (903') whether to trigger a second decoder of the plurality of decoders to decode the encoded input signal based on a determination of whether the first decoded signal is a valid codeword as an estimate of the input signal.

## FIG. 1

200

204

203

202

201

**FIG. 2**

$u \longrightarrow$ | 401 | $x$ | 402 | $\ddot{x}$ | 403 | $y$ | 404 | $\longrightarrow \hat{x}$

**FIG.4A**

**FIG.3**

**FIG.5**

**FIG.4B**

**FIG.4C**

600

$\hat{x}_1$   604   $\hat{x}_1$   601

603

$\hat{x}$   602   $\hat{x}_2$   604   $\hat{x}_2$   601

603

y

$\hat{x}_L$   604   $\hat{x}_L$   601

603

**FIG.6**

701L   no   no   702B   $\hat{x}_2$   701B   no   702A   $\hat{x}_1$   701A

$\hat{x} = \hat{x}_L$

y

yes

$\hat{x} = \hat{x}_2$

yes

$\hat{x} = \hat{x}_1$

**FIG.7**

801   $\hat{x}_1$   802   no   803

y

yes

$\hat{x} = \hat{x}_1$

$\hat{x}$

**FIG.8**

901 → 902 → 903 → 904

**FIG.9A**

901' → 902' → 903'

**FIG.9B**

1001 → 1002 → 1003 → 1004

**FIG.10**